# EUROPÄISCHE PATENTANMELDUNG

(11) **EP 4 654 455 A1**
(43) Veröffentlichungstag der Anmeldung: **26.11.2025**
(21) Anmeldenummer: 24177296.1
(22) Anmeldetag: 22.05.2024
(51) Int. Cl.: H02M 7/219, H02M 7/00, H02M 1/00, H02M 1/42

(54) **ELEKTRONISCHE SCHALTUNG MIT ZWEI ZWISCHENKREISEN, VERFAHREN, LEISTUNGSMODUL UND ELEKTRISCHE VORRICHTUNG**

(71) Anmelder: Diehl AKO Stiftung & Co. KG, 88239 Wangen (DE)
(72) Erfinder: Tinius, Sebastian, 88239 Wangen (DE); Mueller, Alexander, 88339 Bad Waldsee (DE)
(74) Vertreter: Diehl Patentabteilung

(57) **Zusammenfassung**

Offenbart wird eine elektronische Schaltung (102), aufweisend: einen ersten Stromrichter (104) zum Erzeugen einer ersten Zwischenkreisspannung (109) an einem ersten Zwischenkreis (108); einen zweiten Stromrichter zum Erzeugen einer zweiten Zwischenkreisspannung (111) an einem zweiten Zwischenkreis (110); wobei der zweite Stromrichter (106) an den ersten Zwischenkreis (108) angeschlossen ist zum Speisen des zweiten Stromrichters (106) mit der ersten Zwischenkreisspannung (109); und wobei die erste Zwischenkreisspannung (109) sich von der zweiten Zwischenkreisspannung (111) unterscheidet. Ferner werden ein Verfahren, ein Leistungsmodul und eine elektrische Vorrichtung offenbart.

## Beschreibung

### TECHNISCHES GEBIET

Die vorliegende Offenbarung betrifft das Gebiet der Stromrichter.

### HINTERGRUND

US 2022/0320997 A1 offenbart eine Treiberschaltung, welche eine Gleichrichterschaltung, einen Tiefsetzsteller und einen Inverter aufweist. Die Gleichrichterschaltung ist konfiguriert zum Gleichgerichten eines ersten Wechselspannungssignals zum Erzeugen eines gleichgerichteten Spannungssignals. Der Tiefsetzsteller ist konfiguriert zum Tiefsetzen des gleichgerichteten Spannungssignals auf ein DC-Spannungssignal, wobei das DC-Spannungssignal an einen DC-Bus geliefert wird. Der Inverter ist konfiguriert zum Konvertieren des DC-Spannungssignals auf ein zweites AC-Spannungssignal und liefern des zweiten AC-Spannungssignals an einen Kompressormotor und an einen Kondensator-Lüftermotor. Die Scheitelspannungen des zweiten AC-Spannungs-Signals sind niedriger als die Scheitelspannungen des ersten AC-Spannungs-Signals.

### ZUSAMMENFASSUNG

Angesichts der oben beschriebenen Situation kann es ein Bedürfnis geben für eine Technik, welche es erlaubt, einen Betrieb von zwei oder mehr Verbrauchern (beispielsweise Motoren) mit verbesserten Charakteristika bereitzustellen.

Diesem Bedürfnis kann durch die unabhängigen Ansprüche Rechnung getragen werden. Einige vorteilhafte Ausführungsformen sind in den abhängigen Ansprüchen angegeben.

Gemäß einem ersten Aspekt der hierin offenbarten Gegenstände wird eine elektronische Schaltung bereitgestellt.

Gemäß einer Ausführungsform des ersten Aspektes wird eine elektronische Schaltung bereitgestellt, die elektronische Schaltung aufweisend einen ersten Stromrichter zum Erzeugen einer ersten Zwischenkreisspannung an einem ersten Zwischenkreis; einen zweiten Stromrichter zum Erzeugen einer zweiten Zwischenkreisspannung an einem zweiten Zwischenkreis; wobei der zweite Stromrichter an den ersten Zwischenkreis angeschlossen ist zum Speisen des zweiten Stromrichters mit der ersten Zwischenkreisspannung; und wobei die erste Zwischenkreisspannung sich von der zweiten Zwischenkreisspannung unterscheidet.

Gemäß einem zweiten Aspekt der hierin offenbarten Gegenstände wird ein Verfahren bereitgestellt.

Gemäß einer Ausführungsform des zweiten Aspektes wird ein Verfahren bereitgestellt, das Verfahren aufweisend: Erzeugen einer ersten Zwischenkreisspannung aus einer Versorgungsspannung; Erzeugen einer zweiten Zwischenkreisspannung aus der ersten Zwischenkreisspannung.

Gemäß einem dritten Aspekt der hierin offenbarten Gegenstände wird ein Leistungsmodul bereitgestellt.

Gemäß einer Ausführungsform des dritten Aspektes wird ein Leistungsmodul bereitgestellt, das Leistungsmodul aufweisend: einen Stromrichter, welcher betreibbar ist, um aus einer ersten Zwischenkreisspannung eine zweite Zwischenkreisspannung zu erzeugen; und einen weiteren Stromrichter, welcher betreibbar ist, um aus der zweiten Zwischenkreisspannung eine Ausgangsspannung zu erzeugen.

Gemäß einem vierten Aspekt der hierin offenbarten Gegenstände wird eine elektrische Vorrichtung bereitgestellt.

Gemäß einer Ausführungsform des vierten Aspektes wird eine elektrische Vorrichtung bereitgestellt, die elektrische Vorrichtung aufweisend eine elektronische Schaltung gemäß dem ersten Aspekt und/oder ein Leistungsmodul gemäß dem dritten Aspekt.

### BESCHREIBUNG EXEMPLARISCHER AUSFÜHRUNGSFORMEN

Auch wenn hierin bestimmte Nachteile früherer Technologien erwähnt werden, soll der beanspruchte Gegenstand nicht auf Implementierungen beschränkt werden, die einige oder alle der erwähnten Nachteile der früheren Technologien beheben. Ferner soll, auch wenn bestimmte Vorteile der hierin offenbarten Gegenstände in der vorliegenden Offenbarung erwähnt oder impliziert werden, der beanspruchte Gegenstand nicht auf Implementierungen beschränkt werden, die einige oder alle dieser Vorteile aufweisen.

Im Folgenden werden exemplarische Ausführungsformen der hierin offenbarten Gegenstände beschrieben, wobei beispielsweise auf eine elektronische Schaltung, ein Verfahren oder ein Leistungsmodul Bezug genommen wird. Es sollte hervorgehoben werden, dass natürlich jede Kombination von Merkmalen verschiedener Aspekte, Ausführungsformen und Beispiele möglich ist. Insbesondere werden einige Ausführungsformen mit Bezug auf ein Verfahren beschrieben, während andere Ausführungsformen mit Bezug auf eine Vorrichtung (beispielsweise eine elektronische Schaltung, ein Leistungsmodul oder eine elektrische Vorrichtung) beschrieben werden. Wiederum andere Ausführungsformen werden mit Bezug auf eine Steuervorrichtung zum Interagieren mit Elementen der elektronischen Schaltung, des Leistungsmoduls oder der elektrischen Vorrichtung beschrieben werden. Jedoch wird der Fachmann der vorstehenden und der nachfolgenden Beschreibung, den Ansprüchen und den Zeichnungen entnehmen, dass, solange es nicht anders angegeben ist, Merkmale verschiedener Aspekte, Ausführungsformen und Beispiele kombinierbar sind und solche Kombinationen von Merkmalen als durch hierin offenbart anzusehen sind. Beispielsweise ist selbst ein Merkmal, welches sich auf ein Verfahren bezieht, mit einem Merkmal kombinierbar, welches sich auf eine Vorrichtung bezieht, und umgekehrt.

Beispielhafte Implementierungen der hierin offenbarten Gegenstände umfassen insbesondere die nachfolgend beschriebenen Ausführungsformen und Kombinationen von Ausführungsformen.

Gemäß einer Ausführungsform weist eine elektronische Schaltung gemäß dem ersten Aspekt einen ersten Zwischenkreis und einen zweiten Zwischenkreis auf. Gemäß einer weiteren Ausführungsform weist die elektronische Schaltung einen ersten Stromrichter und einen zweiten Stromrichter auf. Gemäß einer Ausführungsform ist der erste Stromrichter konfiguriert zum Erzeugen einer ersten Zwischenkreisspannung an dem ersten Zwischenkreis. Gemäß einer weiteren Ausführungsform ist der zweite Stromrichter konfiguriert zum Erzeugen einer zweiten Zwischenkreisspannung an dem zweiten Zwischenkreis. Gemäß einer Ausführungsform ist der zweite Stromrichter an den ersten Zwischenkreis angeschlossen zum Speisen des zweiten Stromrichters mit der ersten Zwischenkreisspannung. Gemäß einer Ausführungsform unterscheidet sich die erste Zwischenkreisspannung von der zweiten Zwischenkreisspannung. Beispielsweise ist gemäß einer Ausführungsform die erste Zwischenkreisspannung höher als die zweite Zwischenkreisspannung. Beispielsweise beträgt die erste Zwischenkreisspannung 620 V und die zweite Zwischenkreisspannung 300 V.

Gemäß einer Ausführungsform weist ein Verfahren gemäß dem zweiten Aspekt ein Erzeugen einer ersten Zwischenkreisspannung aus einer Versorgungsspannung auf. Gemäß einer weiteren Ausführungsform weist das Verfahren ein Erzeugen einer zweiten Zwischenkreisspannung aus der ersten Zwischenkreisspannung auf.

Gemäß einer Ausführungsform weist ein Leistungsmodul gemäß dem dritten Aspekt eine elektronische Schaltung gemäß Ausführungsformen der hierin offenbarten Gegenstände auf.

Gemäß einer weiteren Ausführungsform weist ein Leistungsmodul einen Stromrichter (beispielsweise einen Spannungssteller) auf, welcher betreibbar ist, um aus einer ersten Zwischenkreisspannung eine zweite Zwischenkreisspannung zu erzeugen. Gemäß einer weiteren Ausführungsform weist das Leistungsmodul einen weiteren Stromrichter (beispielweise einen Inverter) auf, welcher betreibbar ist, um aus der zweiten Zwischenkreisspannung eine Ausgangsspannung zu erzeugen.

Gemäß einer Ausführungsform weist eine elektrische Vorrichtung gemäß dem vierten Aspekt mindestens eines von einer elektronischen Schaltung gemäß dem ersten Aspekt und einem Leistungsmodul gemäß dem dritten Aspekt auf.

Mindestens einige der Aspekte und Ausführungsformen der hierin offenbarten Gegenstände basieren auf der Idee, dass ein Betrieb von zwei oder mehr Verbrauchern mit verbesserten Charakteristika möglich wird, indem zwei Zwischenkreise mit verschiedenen Zwischenkreisspannungen bereitgestellt werden. Beispielsweise kann dadurch ein Betrieb eines ersten Verbrauchers mit hoher Leistung sichergestellt werden, während andererseits ein Betrieb eines zweiten Verbrauchers effizient erfolgen kann und/oder auf eine größere Produktpalette von zweiten Verbrauchern zurückgegriffen werden kann. Indem der zweite Zwischenkreis von dem ersten Zwischenkreis gespeist wird, sind ferner Filterelemente (beispielsweise EMV Filter für bessere elektromagnetische Verträglichkeit), Einschaltstrombegrenzung ein, passive und aktive Leistungsfaktorkorrektur, etc. nur für die Bereitstellung der ersten Zwischenkreisspannung erforderlich. Die Komplexität der elektronischen Schaltung kann dadurch reduziert werden.

Gemäß einer Ausführungsform weisen Halbleiterelemente des ersten Zwischenkreises oder Halbleiterelemente, welche unmittelbar an den ersten Zwischenkreis angeschlossen sind, eine Sperrspannung von 1200 V auf (auch als 1200 V Halbleiter bezeichnet). Gemäß einer weiteren Ausführungsform weisen Halbleiterelemente des zweiten Zwischenkreises oder Halbleiterelemente, welche unmittelbar an den zweiten Zwischenkreis angeschlossen sind, eine Sperrspannung von 600 V auf (auch als 600 V Halbleiter bezeichnet). Folglich kann ein Aufbau der elektronischen Schaltung auf effiziente Weise erfolgen.

Gemäß einer Ausführungsform ist der erste Stromrichter ein Gleichrichter, welche aus einer Versorgungsspannung die erste Zwischenkreisspannung erzeugt. Beispielsweise ist gemäß einer Ausführungsform die Versorgungsspannung eine Dreiphasenwechselspannung eines Stromnetzes. Beispielsweise weist gemäß einer Ausführungsform die Versorgungsspannung zwischen jeweils zwei Phasen einen Effektivwert von 400 V auf.

Gemäß einer Ausführungsform ist der erste Stromrichter konfiguriert, um eine Leistungsfaktorkorrektur zu liefern. Gemäß einer Ausführungsform erzeugt eine Aufnahme von elektrischer Energie durch den ersten Stromrichter (beispielsweise von dem Stromnetz) einen Eingangsstrom, wobei gemäß einer weiteren Ausführungsform eine Leistungsfaktorkorrektur einen Phasenwinkel zwischen der Versorgungsspannung und dem Eingangsstrom liefert, der möglichst nahe bei eins liegt, bei einem möglichst geringen Oberwellengehalt. Gemäß einer Ausführungsform kann der erste Stromrichter konfiguriert sein für eine passive Leistungsfaktorkorrektur. Gemäß einer weiteren Ausführungsform kann der erste Stromrichter konfiguriert sein für eine aktive Leistungsfaktorkorrektur.

Gemäß einer Ausführungsform ist der zweite Stromrichter ein Tiefsetzsteller. Mit anderen Worten ist gemäß einer Ausführungsform die zweite Zwischenkreisspannung niedriger als die erste Zwischenkreisspannung.

Gemäß einer Ausführungsform ist der erste Stromrichter und der zweite Stromrichter an ein gemeinsames Wärmeleitelement gekoppelt. Gemäß einer Ausführungsform kann das Wärmeleitelement eine Wärmesenke sein, beispielsweise ein Kühlkörper oder einen Wärmetauscher. Gemäß einer weiteren Ausführungsform kann das Wärmeleitelement zum Koppeln an eine Wärmesenke vorgesehen sein. Durch ein gemeinsames Wärmeleitelement kann eine Montage der elektronischen Schaltung bzw. eine Montage einer Wärmesenke vereinfacht sein.

Gemäß einer Ausführungsform ist das gemeinsame Wärmeleitelement eine Leiterplatte. Beispielsweise ist die Leiterplatte eine Sandwichstruktur aus mindestens einer Metalllage und mindestens einer Isolatorlage. Beispielsweise kann die Leiterplatte eine Isolatorschicht umfassen, welche auf zwei voneinander abgewandten Seiten jeweils eine Metallschicht aufweist. Gemäß einer Ausführungsform kann eine Metallschicht beispielsweise eine Kupferschicht sein. Gemäß einer weiteren Ausführungsform kann eine Metallschicht eine Aluminiumsschicht sein. Gemäß einer Ausführungsform ist die Leiterplatte eine DBC (direct bonded copper) oder eine DBA (direct bonded aluminum).

Gemäß einer Ausführungsform liefert die Leiterplatte mindestens eines von dem folgenden: (i) eine elektrisch leitende Verbindung mit mindestens einem Teil von elektrischen Anschlüssen des ersten Stromrichters; und (ii) eine elektrisch leitende Verbindung mit mindestens einem Teil von elektrischen Anschlüssen des zweiten Stromrichters. Gemäß einer Ausführungsform sind Bauteile des ersten Stromrichters auf der Leiterplatte montiert und/oder Bauteile des zweiten Stromrichters auf der Leiterplatte montiert. Gemäß einer weiteren Ausführungsform sind Bauteile des ersten Stromrichters mit mindestens einer von mindestens einer Metalllage der Leiterplatte elektrisch leitend verbunden. Gemäß einer weiteren Ausführungsform sind Bauteile des zweiten Stromrichters mit mindestens einer von mindestens einer Metalllage der Leiterplatte elektrisch leitend verbunden. Die mindestens eine Metalllage, welche mit Bauteilen des ersten Stromrichters und/oder des zweiten Stromrichters elektrisch verbunden ist, kann gemäß einer Ausführungsform strukturiert sein, zum Bereitstellen von Leiterbahnen.

Gemäß einer Ausführungsform sind der erste Stromrichter und der zweite Stromrichter in einem gemeinsamen Gehäuse angeordnet. Gemäß einer Ausführungsform weist das gemeinsame Gehäuse das gemeinsame Wärmeleitelement gemäß Ausführungsformen der hierin offenbarten Gegenstände auf.

Gemäß einer Ausführungsform weist die elektronische Schaltung einen dritten Stromrichter auf, welcher an den ersten Zwischenkreis angeschlossen ist, wobei der dritte Stromrichter konfiguriert ist zum Erzeugen einer ersten Ausgangsspannung aus der ersten Zwischenkreisspannung. Gemäß einer Ausführungsform kann die erste Ausgangsspannung konfiguriert sein zum Ansteuern eines ersten Verbrauchers, beispielsweise eines ersten Motors.

Gemäß einer weiteren Ausführungsform weist die elektronische Schaltung einen vierten Stromrichter auf, welcher an den zweiten Zwischenkreis angeschlossen ist, wobei der vierte Stromrichter konfiguriert ist, zum Erzeugen einer zweiten Ausgangsspannung aus der zweiten Zwischenkreisspannung. Beispielsweise kann gemäß einer Ausführungsform die zweite Ausgangsspannung konfiguriert sein zum Ansteuern eines zweiten Verbrauchers, beispielsweise eines zweiten Motors.

Analog weist gemäß einer Ausführungsform ein Verfahren ein Erzeugen einer ersten Ausgangsspannung aus der ersten Zwischenkreisspannung und ein Erzeugen einer zweiten Ausgangsspannung aus der zweiten Zwischenkreisspannung auf. Gemäß einer Ausführungsform ist die zweite Ausgangsspannung kleiner als die erste Ausgangsspannung

Gemäß einer Ausführungsform sind der erste Verbrauchern der zweite Verbraucher von verschiedenem Typ. Beispielsweise ist gemäß einer Ausführungsform der erste Verbraucher für 400 V AC ausgelegt und der zweite Verbraucher ist für 200 V AC ausgelegt. Abhängig von der Anwendung können für eine niedrigere Ausgangsspannung geeignetere, effizientere oder auch in einer größeren Produktpalette verfügbare Verbraucher erhältlich sein. Auf diese Weise kann eine elektrische Vorrichtung, welche die elektronische Schaltung und den ersten und den zweiten Verbraucher aufweist, effizienter sein oder in breiterer Vielfalt konfigurierbar sein.

Gemäß einer Ausführungsform ist mindestens einer von dem dritten Stromrichter und dem vierten Stromrichter ein Inverter. Beispielsweise ist der dritte Stromrichter konfiguriert zum Ansteuern eines ersten Verbrauchers, beispielsweise eines ersten Motors. Gemäß einer Ausführungsform können zwei oder mehr erste Verbraucher vorgesehen sein, die gemäß einer weiteren Ausführungsform von jeweils einem eigenen dritten Stromrichter angesteuert werden. Entsprechend können gemäß einer Ausführungsform zwei oder mehr dritte Stromrichter vorgesehen sein. Gemäß einer weiteren Ausführungsform ist der vierte Stromrichter konfiguriert zum Ansteuern eines zweiten Verbrauchers, beispielsweise eines zweiten Motors. Gemäß einer weiteren Ausführungsform können weitere erste Verbraucher und/oder weitere zweite Verbraucher vorgesehen sein. Beispielsweise ist gemäß einer Ausführungsform ein einziger erster Verbraucher und mindestens ein zweiter Verbraucher (beispielsweise zwei oder mehr zweite Verbraucher) vorgesehen. Gemäß einer Ausführungsform sind der zweite Stromrichter und mindestens ein vierter Stromrichter von dem mindestens einen vierten Stromrichter an ein gemeinsames Wärmeleitelement gekoppelt und/oder in einem gemeinsamen Gehäuse angeordnet, insbesondere wobei das gemeinsame Wärmeleitelement eine Leiterplatte ist. Beispielsweise ist das gemeinsame Wärmeleitelement an welchem der zweite Stromrichter und mindestens ein vierter Stromrichter gekoppelt sind, ein hierin beschriebenes Wärmeleitelement, beispielsweise das Wärmeleitelement, an welches auch der erste Stromrichter gekoppelt ist.

Gemäß einer Ausführungsform sind der erste Stromrichter, der zweite Stromrichter und der dritte Stromrichter an ein gemeinsames Wärmeleitelement gekoppelt. Allgemein können gemäß einer Ausführungsform zwei oder mehr der hierin offenbarten Stromrichter an ein gemeinsames Wärmeleitelement gekoppelt sein.

Gemäß einer weiteren Ausführungsform sind der zweite Stromrichter und der dritte Stromrichter in einem gemeinsamen Gehäuse angeordnet. Allgemein können gemäß einer Ausführungsform zwei oder mehr der hierin offenbarten Stromrichter in einem gemeinsamen Gehäuse angeordnet sein.

Gemäß einer Ausführungsform weist die elektronische Schaltung eine erste Steuervorrichtung zum Steuern des ersten Stromrichters und eine zweite Steuervorrichtung zum Steuern des zweiten Stromrichters auf. Gemäß einer Ausführungsform sind die erste Steuervorrichtung und die zweite Steuervorrichtung separate Steuervorrichtungen. Gemäß einer anderen Ausführungsform sind die erste Steuervorrichtungen die zweite Steuervorrichtung durch eine gemeinsame Steuervorrichtung implementiert.

Gemäß einer Ausführungsform ist die erste Steuervorrichtung ferner zum Steuern des dritten Stromrichters konfiguriert. Gemäß einer weiteren Ausführungsform ist die zweite Steuervorrichtung ferner zum Steuern des vierten Stromrichters konfiguriert. Allgemein können Elemente des zweiten Zwischenkreises und hieran angeschlossene Komponenten durch die zweite Steuervorrichtung gesteuert werden und, gemäß einer weiteren Ausführungsform, die verbleibenden Elemente durch die erste Steuervorrichtung.

Gemäß einer Ausführungsform ist der Stromrichter des Leistungsmoduls der hierin beschriebene dritte Stromrichter. Gemäß einer weiteren Ausführungsform ist der weitere Stromrichter des Leistungsmoduls der hierin beschriebene vierte Stromrichter. Mit anderen Worten können insbesondere der dritte Stromrichter und der vierte Stromrichter Teil eines Leistungsmoduls gemäß Ausführungsformen der hierin offenbarte Gegenstände sein.

Gemäß einer weiteren Ausführungsform sind der der Stromrichter und der weitere Stromrichter des Leistungsmoduls in einem gemeinsamen Gehäuse angeordnet. Auf diese Weise kann eine Montage des Spannungsstellers und des Inverter vereinfacht werden, beispielsweise eine Montage an eine Wärmesenke oder eine Montage des Spannungsteilers und des Inverters in eine hierin offenbarte elektrische Vorrichtung.

Nachdem eine elektronische Schaltung oder ein Leistungsmodul gemäß Ausführungsformen der hierin offenbarten Gegenstände ein Bedienen von mehreren Verbrauchern (beispielsweise Motoren) erlaubt, kann eine solche elektronische Schaltung oder ein solches Leistungsmodul auch als Multi-Inverter bezeichnet werden. Allgemein kann ein Leistungsmodul gemäß einer Ausführungsform zwei oder mehr der hierin offenbarten Stromrichter aufweisen. Beispielsweise kann ein Leistungsmodul (lediglich) den ersten und den zweiten Stromrichter aufweisen.

Gemäß Ausführungsformen des ersten Aspektes ist die elektronische Schaltung eingerichtet zum Liefern der Funktionalität von einem oder mehreren der hierin offenbarten Ausführungsformen und/oder zum Liefern der Funktionalität, wie sie erforderlich ist für eine oder mehrere der hierin offenbarten Ausführungsformen, insbesondere der Ausführungsformen des ersten Aspektes, des zweiten Aspektes, des dritten Aspektes und/oder des vierten Aspektes.

Gemäß Ausführungsformen des zweiten Aspektes ist das Verfahren eingerichtet zum Liefern der Funktionalität von einem oder mehreren der hierin offenbarten Ausführungsformen und/oder zum Liefern der Funktionalität, wie sie erforderlich ist für eine oder mehrere der hierin offenbarten Ausführungsformen, insbesondere der Ausführungsformen des ersten Aspektes, des zweiten Aspektes, des dritten Aspektes und/oder des vierten Aspektes.

Gemäß Ausführungsformen des dritten Aspektes ist das Leistungsmodul eingerichtet zum Liefern der Funktionalität von einem oder mehreren der hierin offenbarten Ausführungsformen und/oder zum Liefern der Funktionalität, wie sie erforderlich ist für eine oder mehrere der hierin offenbarten Ausführungsformen, insbesondere der Ausführungsformen des ersten Aspektes, des zweiten Aspektes, des dritten Aspektes und/oder des vierten Aspektes.

Gemäß Ausführungsformen des vierten Aspektes ist die elektrische Vorrichtung eingerichtet zum Liefern der Funktionalität von einem oder mehreren der hierin offenbarten Ausführungsformen und/oder zum Liefern der Funktionalität, wie sie erforderlich ist für eine oder mehrere der hierin offenbarten Ausführungsformen, insbesondere der Ausführungsformen des ersten Aspektes, des zweiten Aspektes, des dritten Aspektes und/oder des vierten Aspektes.

Es wird angemerkt, dass eine Bezugnahme auf einen Aspekt der hierin offenbarten Gegenstände selbstverständlich eine Bezugnahme auf eine oder mehrere Ausführungsformen des Aspektes umfasst. Beispielsweise umfasst die Angabe, dass eine elektrische Vorrichtung eine elektronische Schaltung gemäß dem ersten Aspekt aufweist, Ausführungsformen, gemäß welchen die elektronische Schaltung nach einer oder mehreren Ausführungsformen des ersten Aspektes ausgebildet ist.

Gemäß einer Ausführungsform ist das Programmelement ein nicht-transientes Programmelement. Gemäß einer weiteren Ausführungsform ist das Computerprogrammprodukt ein nicht-transientes Computerprogrammprodukt.

Wie hierin verwendet wird die Bezugnahme auf ein Computerprogrammprodukt, welches ein Programmelement aufweist, als äquivalent angesehen zu einer Bezugnahme auf ein Computerprogramm, welches ein Programmelement aufweist und/oder ein computerlesbares Medium, welches ein Programmelement aufweist. Gemäß einer Ausführungsform weist das Programmelement Instruktionen zum Steuern einer Prozessorvorrichtung (mit einem oder mehreren Mikroprozessoren, beispielsweise ein Computersystem) auf, zum Bewirken und/oder Koordinieren der Ausführung von mindestens einem hierein beschriebenen Verfahren.

Das (nicht-transiente) Programmelement kann implementiert sein als computerlesbarer Instruktionscode unter Verwendung von jeder geeigneten Programmiersprache, wie beispielsweise C, C++ oder Assemblersprache, etc. und kann auf einem computerlesbaren Medium (entfernbare Platte, flüchtiger oder nichtflüchtiger Speicher, Embedded-Speicher/Prozessor, etc.) gespeichert sein. Gemäß einer Ausführungsform ist der Instruktionscode ausführbar zum Programmieren eines Computers oder irgendeiner anderen programmierbaren Prozessorvorrichtung zum Ausführen der beabsichtigten Funktionen. Das Computerprogramm kann in einem Netzwerk verfügbar sein, beispielsweise dem World Wide Web, von welchem es beispielsweise heruntergeladen werden kann.

Die hierin offenbarten Gegenstände können mittels eines Computerprogrammprodukts (Programmelements) respektive Software realisiert werden. Jedoch können die hierin offenbarten Gegenstände ebenso durch einen oder mehrere spezifische Schaltungen, respektive Hardware realisiert werden. Ferner können die hierin offenbarten Gegenstände ebenso in Hybridform, d. h. In einer Kombination von Softwaremodulen und Hardwaremodulen realisiert werden.

Gemäß einer Ausführungsform können eine oder mehrere der hierin offenbarten Steuervorrichtungen eine Prozessorvorrichtung aufweisen, welche zur Ausführung eines hierin offenbarten Programmelements konfiguriert ist.

Gemäß einer weiteren Ausführungsform ist ein Zahlenwert ein Nennwert, für den eine Vorrichtung spezifiziert ist. Jedoch können Abweichungen von dem Nennwert z. B. im Rahmen üblicher Toleranzen, Spezifikationen oder Normen zulässig sein.

Gemäß einer Ausführungsform kann ein hierin offenbartes Verfahren die Funktionalität einer hierin offenbarten Vorrichtung definieren, ohne auf die vorrichtungsspezifischen Merkmale beschränkt zu sein. Insofern soll jede hierin offenbarte Funktionalität einer hierin offenbarten Vorrichtung implizit ein entsprechendes Verfahren offenbaren, welches ausschließlich durch die offenbarte Funktionalität definiert ist. Umgekehrt kann gemäß einer Ausführungsform ein hierin offenbartes Verfahren mit jeder geeigneten bekannten Vorrichtung (die ein einziges Element oder mehrere zusammenwirkende Elemente aufweisen kann) ausgeführt werden. Insofern soll jedes hierin offenbarte Verfahren implizit eine entsprechende Vorrichtung offenbaren, welche konfiguriert ist, um das Verfahren auszuführen.

Eine allgemeine Bezugnahme auf Ausführungsformen (beispielsweise einer elektronischen Schaltung), zum Beispiel durch die Formulierung "gemäß mindestens einer Ausführungsform", durch die Formulierung "gemäß einer oder mehreren Ausführungsformen" oder die Formulierung "gemäß Ausführungsformen" umfasst insbesondere auch die Merkmalskombination eines entsprechenden unabhängigen Anspruchs ohne weitere Einschränkungen (beispielsweise die elektronische Schaltung gemäß Anspruch 1).

Solange nicht ausdrücklich etwas anderes angegeben ist, definiert eine Auflistung von Merkmalen oder Prozessschritten gemäß einer Ausführungsform noch nicht eine Reihenfolge der Merkmale oder der Prozessschritte in der Reihenfolge der Auflistung. Gemäß einer weiteren Ausführungsform definiert eine Auflistung von Merkmalen oder Prozessschritten eine Reihenfolge der Merkmale oder Prozessschritte wie in der Auflistung angegeben.

Vorstehend wurde in einigen Ausführungsformen beim ersten Auftreten eines Merkmals auf das Merkmal mit dem unbestimmten Artikel Bezug genommen, z.B. sowohl bei der Beschreibung von Ausführungsformen des ersten Aspekts als auch bei der Beschreibung von Ausführungsformen des zweiten Aspekts. Es sollte sich jedoch verstehen, dass die Verwendung des unbestimmten Artikels in dieser Offenbarung nicht einschränkend ist und dass ein Merkmal, auf das in verschiedenen Ausführungsformen Bezug genommen wird, unabhängig davon, ob es mit dem definierten Artikel oder mit dem unbestimmten Artikel bezeichnet wird, sich jedenfalls zumindest in einer Ausführungsform auf dasselbe Merkmal bezieht und daher in einer Kombination verschiedener Ausführungsformen das Merkmal beim ersten Auftreten des Merkmals mit dem unbestimmten Artikel und bei den weiteren Vorkommen des Merkmals mit dem definierten Artikel referenziert werden kann. Außerdem sind in einer Ausführungsform der erste Aspekt und der zweite Aspekt zwei verschiedene Aspekte desselben Gegenstands.

Weitere Vorteile und Merkmale der vorliegenden Offenbarung ergeben sich aus der folgenden beispielhaften Beschreibung derzeit bevorzugter Ausführungsformen, auf welche die beanspruchten Gegenstände jedoch nicht beschränkt ist. Die einzelnen Figuren der Zeichnungen dieses Dokuments sind lediglich als schematisch und als nicht maßstabsgetreu anzusehen.

### KURZE BESCHREIBUNG DER ZEICHNUNGEN

Fig. 1 zeigt eine elektrische Vorrichtung gemäß Ausführungsformen der hierin offenbarten Gegenstände.
Fig. 2 zeigt eine beispielhafte Implementierung des ersten Stromrichters der elektrischen Vorrichtung aus Fig. 1 gemäß Ausführungsformen der hierin offenbarten Gegenstände.
Fig. 3 zeigt eine beispielhafte Implementierung des zweiten Stromrichters und des vierten Stromrichters der elektrischen Vorrichtung aus Fig. 1 gemäß Ausführungsformen der hierin offenbarten Gegenstände.
Fig. 4 zeigt eine weitere beispielhafte Implementierung des zweiten Stromrichters und des vierten Stromrichters der elektrischen Vorrichtung aus Fig. 1 gemäß Ausführungsformen der hierin offenbarten Gegenstände.
Fig. 5 zeigt ein weiteres Leistungsmodul gemäß Ausführungsformen der hierin offenbarten Gegenstände.
Fig. 6 zeigt ein weiteres Leistungsmodul gemäß Ausführungsformen der hierin offenbarten Gegenstände.
Fig. 7 zeigt in einer Querschnittsansicht eine Implementierung des Leistungsmoduls aus Fig. 5 gemäß Ausführungsformen der hierin offenbarten Gegenstände.
Fig. 8 zeigt ein weiteres Leistungsmodul gemäß Ausführungsformen der hierin offenbarten Gegenstände.

### DETAILLIERTE BESCHREIBUNG

Es wird angemerkt, dass in verschiedenen Figuren ähnliche oder identische Elemente oder Komponenten mit denselben Bezugszahlen versehen sind, oder mit Bezugszahlen, die sich nur in der führenden Ziffer oder einem angehängten Buchstaben unterscheiden. Solche Merkmale bzw. Komponenten, die mit den entsprechenden Merkmalen bzw. Komponenten in einer anderen Figur gleich oder zumindest funktionsgleich sind, werden nur bei ihrem ersten Auftreten in dem nachfolgenden Text detailliert beschrieben und die Beschreibung wird bei nachfolgendem Auftreten dieser Merkmale und Komponenten (bzw. der entsprechenden Bezugszahlen) nicht wiederholt.

Es versteht sich, dass eine beispielhafte Implementierung der nachfolgend beschriebenen und mit Bezugszeichen versehenen Elemente in den betreffenden Zeichnungen dargestellt und gemäß der nachfolgenden Beschreibung konfiguriert sind, sofern nicht etwas anderes angegeben ist.

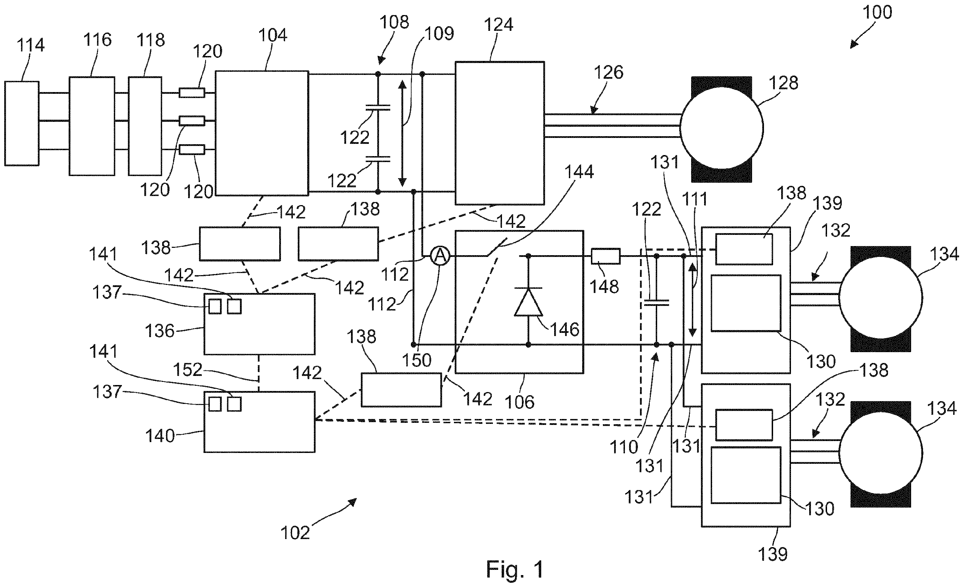

Fig. 1 zeigt eine elektrische Vorrichtung 100 gemäß Ausführungsformen der hierin offenbarten Gegenstände.

Gemäß einer Ausführungsform weist die elektrische Vorrichtung 100 eine elektronische Schaltung 102 auf. Gemäß einer Ausführungsform weist die elektronische Schaltung 102 einen ersten Stromrichter 104 und einen zweiten Stromrichter 106 auf. Ferner weist die elektronische Schaltung 102 einen ersten Zwischenkreis 108 und einen zweiten Zwischenkreis 110 auf. Gemäß einer Ausführungsform ist der erste Stromrichter konfiguriert zum Erzeugen einer ersten Zwischenkreisspannung 109 an dem ersten Zwischenkreis 108 und der zweite Stromrichter 106 ist konfiguriert zum Erzeugen einer zweiten Zwischenkreisspannung 111 an dem zweiten Zwischenkreis 110. Gemäß einer weiteren Ausführungsform ist der zweite Stromrichter 106 an den ersten Zwischenkreis 108 angeschlossen, angegeben bei 112, zum Speisen des zweiten Stromrichters 106 mit der ersten Zwischenkreisspannung 109 des ersten Zwischenkreises 108, beispielsweise wie in Fig. 1 dargestellt.

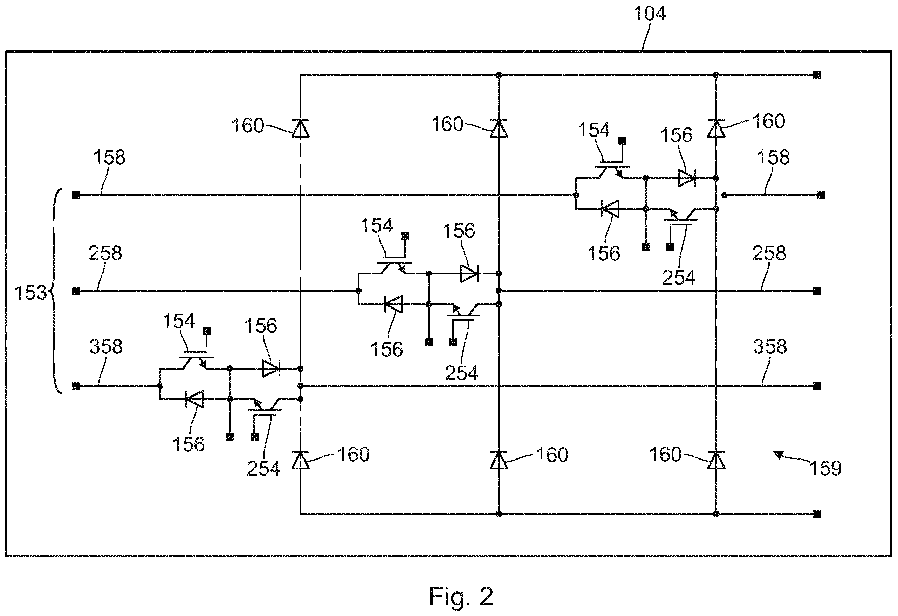

Gemäß einer Ausführungsform ist der erste Stromrichter 104 ein Gleichrichter, welcher aus einer Versorgungsspannung, beispielsweise eines Stromnetzes 114, die erste Zwischenkreisspannung 109 erzeugt. Gemäß einer Ausführungsform ist der erste Stromrichter 104 konfiguriert, um eine Leistungsfaktorkorrektur zu liefern, beispielsweise eine aktive Leistungsfaktorkorrektur, beispielsweise wie nachfolgend mit Bezug auf Fig. 2 erläutert. Gemäß einer weiteren Ausführungsform weist die elektronische Schaltung 102 einen EMV-Filter 116 auf, d. h. einen Filter, welcher die elektromagnetische Verträglichkeit verbessert, beispielsweise wie in Fig. 1 dargestellt.

Gemäß einer weiteren Ausführungsform weist die elektronische Schaltung 102 eine Einschaltstrombegrenzung und eine Vorrichtung (beispielsweise ein Relais) zum Überbrücken der Einschaltstrombegrenzung auf, beides angegeben bei 118 in Fig. 1. Die Einschaltstrombegrenzung kann beispielsweise einen Festwiderstand umfassen oder durch einen Festwiderstand gebildet sein. Durch Überbrücken der Einschaltstrombegrenzung werden unnötige elektrische Verluste an der Einschaltstrombegrenzung (beispielsweise an dem Festwiderstand) nach dem Einschalten vermieden.

Gemäß einer Ausführungsform weist die elektronische Schaltung 102 mindestens ein Element 120 zur passiven Leistungsfaktorkorrektur auf, beispielsweise ein Dämpfungselement (PFC Choke) zum Reduzieren eines Stromrippels, welcher durch den Betrieb der elektronischen Schaltung 102 in das Stromnetz 114 übertragen werden kann. Beispielsweise kann für jede Phase des ersten Stromrichters 104 ein Element 120 vorgesehen sein, beispielsweise wie in Fig. 1 dargestellt.

Der erste Zwischenkreis 108 weist gemäß einer Ausführungsform eines oder mehrere kapazitive Elemente 122 auf, beispielsweise zwei kapazitive Elemente 122, beispielsweise wie in Fig. 1 dargestellt. Gemäß einer Ausführungsform sind zwei oder mehr der kapazitive Elemente 122 in Reihe geschaltet, um die Spannung an jedem einzelnen Element 122 in einem zulässigen Betriebsbereich zu halten.

Gemäß einer Ausführungsform beträgt die erste Zwischenkreisspannung 109 an dem ersten Zwischenkreis 108 ca. 600 V bis 650 V (Gleichspannung, DC), bei einer typischen Netzspannung von 400V (Wechselspannung, AC). Bei einer rein passiven Leistungsfaktorkorrektur kann eine typische erste Zwischenkreisspannung 109 bei ca. 540 V bis 570 V (DC) liegen, bei einer typischen Netzspannung von 400V (Wechselspannung, AC).

Gemäß einer Ausführungsform ist der zweite Stromrichter 106 ein Tiefsetzsteller, beispielsweise wie in Fig. 1 dargestellt, d. h. die zweite Zwischenkreisspannung 111 an dem zweiten Zwischenkreis 110 ist niedriger als die erste Zwischenkreisspannung 109 an dem ersten Zwischenkreis 108. Gemäß einer Ausführungsform weist auch der zweite Zwischenkreis 110 eines oder mehrere kapazitive Elemente, beispielsweise ein einziges kapazitives Element 122, auf, beispielsweise wie in Fig. 1 dargestellt.

Gemäß einer Ausführungsform beträgt die zweite Zwischenkreisspannung 111 ca. 300 V bis 400 V (DC).

Gemäß einer Ausführungsform weist die elektronische Schaltung 102 einen dritten Stromrichter 124, beispielsweise einen Inverter, auf, welcher an den ersten Zwischenkreis 108 angeschlossen ist zum Erzeugen einer ersten Ausgangsspannung 126 zum Ansteuern eines ersten Verbrauchers 128, beispielsweise eines ersten Motors. Gemäß einer Ausführungsform ist der erste Verbraucher 128 auf eine maximale Arbeitsspannung von ca. 400 V (Wechselspannung, AC) ausgelegt, beispielsweise 400 V.

Gemäß einer weiteren Ausführungsform weist die elektronische Schaltung 102 mindestens einen vierten Stromrichter 130 auf, beispielsweise zwei vierte Stromrichter 130, beispielsweise wie in Fig. 1 dargestellt. Gemäß einer Ausführungsform ist der vierte Stromrichter 130 ein Inverter, welcher an den zweiten Zwischenkreis 110 angeschlossen ist (schematisch dargestellt bei 131) zum Erzeugen einer zweiten Ausgangsspannung, angegeben bei 132 in Fig. 1.

Gemäß einer Ausführungsform ist der vierte Stromrichter 130 konfiguriert, zum Ansteuern eines zweiten Verbrauchers 134 beispielsweise wie in Fig. 1 dargestellt. Insbesondere ist jedem vierten Stromrichter 130 ein zweiter Verbraucher 134 zugeordnet, welcher von dem zugeordneten vierten Stromrichter 130 angesteuert wird, beispielsweise wie in Fig. 1 dargestellt.

Gemäß einer Ausführungsform ist die elektrische Vorrichtung 100 eine Wärmepumpe und der erste Verbraucher 128 ist ein Motor eines Kompressors (maximale Arbeitsspannung ca. 400 V) der Wärmepumpe und jeder zweite Verbraucher 134 ist ein Motor eines Lüfters (maximale Arbeitsspannung ca. 200 V) der Wärmepumpe. Gemäß einer Ausführungsform sind die Leistungshalbleiter zur Ansteuerung des ersten Verbrauchers 128 jeweils 1200 V Halbleiter und die Halbleiter zur Ansteuerung der zweiten Verbraucher 134 jeweils 600 V Halbleiter.

Gemäß einer Ausführungsform weist die elektronische Schaltung 102 eine erste Steuervorrichtung 136 auf zum Steuern des ersten Stromrichters 104, beispielsweise wie in Fig. 1 dargestellt. Gemäß einer Ausführungsform ist die erste Steuervorrichtung 136 ferner konfiguriert zum Steuern des dritten Stromrichters 124, beispielsweise wie in Fig. 1 dargestellt. Gemäß einer Ausführungsform ist dem ersten Stromrichter 104 und dem dritten Stromrichter 124 jeweils mindestens ein Treiber zugeordnet, zum Ansteuern von Elementen (beispielsweise Schaltern) des ersten Stromrichters 104 bzw. des dritten Stromrichters 124. Der mindestens eine Treiber ist in Fig. 1 schematisch bei 138 angegeben. Die erste Steuervorrichtung 136 steuert und/oder regelt (angegeben bei 142) in gemäß einer Ausführungsform über mindestens einen Treiber 138 den ersten Stromrichter 104 (d. h. die Gleichrichtung und aktive Leistungsfaktorkorrektur). Eine entsprechende steuerungsmäßige Verbindung ist in Fig. 1 bei 142 angegeben. Ferner steuert und/oder regelt (angegeben bei 142) gemäß einer Ausführungsform die erste Steuervorrichtung 136 über mindestens einen Treiber 138 den dritten Stromrichter 124, beispielsweise wie in Fig. 1 dargestellt.

Gemäß einer Ausführungsform weist die elektronische Schaltung 102 eine zweite Steuervorrichtung 140 auf zum Steuern des zweiten Stromrichters 106, beispielsweise wie in Fig. 1 dargestellt. Gemäß einer weiteren Ausführungsform ist die zweite Steuervorrichtung 140 konfiguriert zum Steuern von mindestens einem vierten Stromrichter 130, beispielsweise wie in Fig. 1 dargestellt. Gemäß einer Ausführungsform ist dem zweiten Stromrichter 106 und jedem vierten Stromrichter 130 jeweils mindestens ein Treiber 138 zugeordnet zum Ansteuern von Elementen (beispielsweise Schaltern) des zweiten Stromrichters 106 bzw. des zugeordneten vierten Stromrichters 130. Gemäß einer Ausführungsform ist mindestens einer von dem mindestens einen vierten Stromrichter 130 mit seinem zugeordneten mindestens einen Treiber 138 in einer Baugruppe 139 integriert, beispielsweise wie in Fig. 1 dargestellt. Beispielsweise kann der vierte Stromrichter 130 mit seinem zugeordneten mindestens einen Treiber 138 gemäß einer Ausführungsform in einem gemeinsamen Gehäuse angeordnet sein. Obwohl in Fig. 1 zwei vierte Stromrichter 130 dargestellt sind, versteht es sich, dass gemäß anderen Ausführungsformen nur ein einziger vierter Stromrichter 130 vorgesehen sein kann, oder mehr als zwei vierte Stromrichter 130.

Gemäß einer Ausführungsform steuert und/oder regelt (angegeben bei 142 in Fig. 1) die zweite Steuervorrichtung 140 über mindestens einen Treiber 138 den zweiten Stromrichter 106 (beispielsweise durch Ansteuern eines Schalters 144 des zweiten Stromrichters 106), beispielsweise wie in Fig. 1 angegeben. Gemäß einer Ausführungsform weist jede Steuervorrichtung 136, 140 einen Speicher 137 auf (welcher beispielsweise ein Programmelement gemäß Ausführungsformen der hierin offenbarten Gegenstände aufweist), sowie eine Prozessorvorrichtung 141.

Gemäß einer Ausführungsform weist der zweite Stromrichter 106 den Schalter 144 sowie eine Diode 146 auf. Eine Strommessvorrichtung 150 ist dem zweiten Stromrichter 106 vorgeschaltet. Ein Induktor 148 ist dem zweiten Stromrichter 106 nachgeschaltet. Ein Induktor 148 kann hierbei jedes Bauelement sein, welches eine Induktivität liefert. Die Strommessvorrichtung 150 kann beispielsweise gemäß einer Ausführungsform ein Magnetwiderstandssensor oder ein Hallsensor sein. Gemäß einer Ausführungsform ist der Schalter 144 ein Leistungshalbleiter, beispielsweise einem Siliziumcarbid-Metalloxid-Feldeffekttransistor (SiC-MOSFET) oder ein Bipolartransistor mit isolierten Gate (IGBT), beispielsweise ein Silizium-IGBT (Si-IGBT). Gemäß einer Ausführungsform umfasst der Schalter 144 ferner eine Freilaufdiode (in Fig. 1 nicht dargestellt). Die Freilaufdiode kann in bekannter Weise durch den Aufbau des Halbleiterschalters bedingt sein, beispielsweise dadurch, dass bei einem Feldeffekttransistor Source mit Bulk verbunden wird. Abhängig vom Aufbau des Schalters 144 kann dieser daher eine Freilaufdiode mit umfassen, ohne dass diese Freilaufdiode nachfolgend explizit erwähnt wird. Gemäß einer Ausführungsform ist die Diode 146 ein Leistungshalbleiter, beispielsweise eine Siliziumdiode oder eine Siliziumcarbid-Diode.

Die Leistungshalbleiter 144, 146 des zweiten Stromrichters 106 erzeugen elektrische Verluste (Leitungsverluste und Schaltverluste) welche in Form von Wärme an die Umgebung abgegeben werden. Gemäß einer Ausführungsform werden der Schalter 144 und die Diode 146 daher an eine Wärmesenke, beispielsweise einen Kühlkörper, thermisch angebunden (beispielsweise mit einem Kühlkörper thermisch gekoppelt).

Wie erläutert ist der zweite Stromrichter 106 gemäß einer Ausführungsform ein Tiefsetzsteller. Ein Tiefsetzsteller ist eine gängige Schaltung zur Reduzierung einer ersten Spannung (beispielsweise der ersten Zwischenkreisspannung 109) auf eine kleinere zweite Spannung (beispielsweise die zweite Zwischenkreisspannung 111) und wird daher in seiner Funktionsweise nicht näher erläutert. Gemäß einer weiteren Ausführungsform kann der zweite Stromrichter 106 auch anderweitig ausgebildet sein.

Gemäß einer Ausführungsform sind die erste Steuervorrichtung 136 und die zweite Steuervorrichtung 140 kommunikativ gekoppelt, angegeben bei 152, zum miteinander Kommunizieren der ersten Steuervorrichtung 136 und der zweiten Steuervorrichtung 140.

Fig. 2 zeigt eine beispielhafte Implementierung des ersten Stromrichters 104 aus Fig. 1 gemäß Ausführungsformen der hierin offenbarten Gegenstände.

Gemäß einer Ausführungsform hat der erste Stromrichter 104 einen dreiphasigen Eingang 153, mit einer ersten Phase 158, einer zweiten Phase 258 und einer dritten Phase 358, beispielsweise wie in Fig. 2 dargestellt. Gemäß einer Ausführungsform weist der erste Stromrichter 104 sechs Schalter 154, 254 auf, sowie sechs Freilaufdioden 156 die antiparallel zu den Schaltern 154, 254 geschaltet sind, beispielsweise wie in Fig. 2 dargestellt. Die antiparallelen Freilaufdioden 156 können wie beschrieben durch die interne Verschaltung der Schalter 154, 254 bedingt sein. Gemäß einer Ausführungsform weist jede Phase 158, 258, 358 für jede Stromrichtung (bzw. für jede an der Phase 158, 258, 358 anliegende Polarität) einen Schalter 154, 254 auf, beispielsweise wie in Fig. 2 dargestellt. Beispielsweise weist jede Phase 158, 258 358 einen ersten Schalter 154 auf, welcher einen Stromfluss in einer ersten Stromrichtung sperren kann und einen zweiten Schalter 254, welcher einen Stromfluss in einer zweiten Stromrichtung, die der ersten Stromrichtung entgegengesetzt ist, sperren kann, beispielsweise wie in Fig. 2 dargestellt.

Durch geeignete Ansteuerung der ersten Schalter 154 und der zweiten Schalter 254 durch die erste Steuervorrichtung 136 (vergleiche Fig. 1) wird eine aktive Leistungsfaktorkorrektur und ein geringer Oberwellenanteil (insbesondere in den zweiten und höheren Oberwellen) in den Phasenströmen der einzelnen Phasen 158, 258, 358 ermöglicht.

Gemäß einer Ausführungsform weist der erste Stromrichter 104 ferner eine Brückenschaltung 159 auf, beispielsweise eine sechs-Puls-Brückenschaltung, welche sechs Dioden 160 aufweist, beispielsweise wie in Fig. 2 dargestellt.

Gemäß einer Ausführungsform ist der erste Stromrichter 104 ein gesteuerter Gleichrichter, beispielsweise ein "Vienna"-Gleichrichter (Gleichrichter vom Vienna-Typ) mit aktiver Leistungsfaktorkorrektur, beispielsweise wie in Fig. 2 dargestellt. Andere Schaltungstopologien sind jedoch ebenso möglich. In Fig. 2 sind lediglich die Schalter und Dioden des ersten Stromrichters 104 dargestellt. Die Funktionsweise ist jedoch bekannt (beispielsweise, gemäß einer Ausführungsform, aus der europäischen Patentanmeldung EP 0 660 498 A2) und wird daher nicht weiter beschrieben.

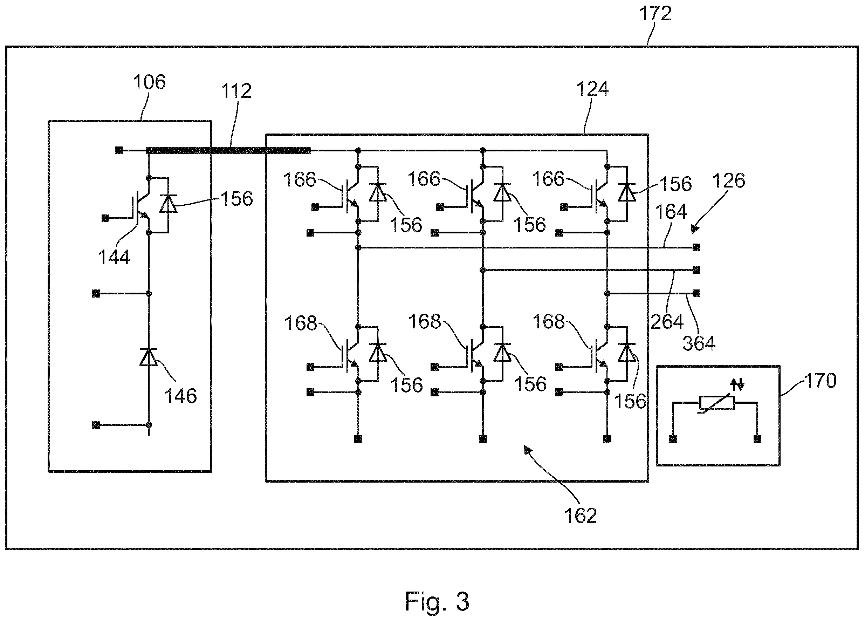

Fig. 3 zeigt eine beispielhafte Implementierung des zweiten Stromrichters 106 und des dritten Stromrichters 124 aus Fig. 1 gemäß Ausführungsformen der hierin offenbarten Gegenstände.

Gemäß einer Ausführungsform ist der zweite Stromrichter 106 ein Tiefsetzsteller, beispielsweise wie in Fig. 3 dargestellt. Gemäß einer Ausführungsform weist der Schalter 144 des zweiten Stromrichters 106 eine Freilaufdiode 156 auf, beispielsweise wie in Fig. 3 dargestellt. Die Diode 146 und der Induktor 148 wurde bereits mit Bezug auf Fig. 1 beschrieben. Gemäß einer Ausführungsform wird von dem zweiten Stromrichter 106 und dritten Stromrichter 124 ein gemeinsamer Anschluss an den ersten Zwischenkreis 112 genutzt, beispielsweise wie in Fig. 3 dargestellt.

Der dritte Stromrichter 124, der gemäß einer Ausführungsform ein Inverter ist, weist gemäß einer weiteren Ausführungsform eine gesteuerte Vollbrücke 162 auf, beispielsweise wie in Fig. 3 dargestellt. Gemäß einer Ausführungsform weist die Vollbrücke für jede von drei Ausgangsphasen 164, 264, 364 einen ersten Schalter 166 und einen zweiten Schalter 168 auf, beispielsweise wie in Fig. 3 dargestellt. Gemäß einer Ausführungsform weist jeder Schalter 166, 168 eine Freilaufdiode 156 auf, beispielsweise wie in Fig. 3 dargestellt. Durch geeignete Ansteuerung der Schalter 166, 168 wird durch den dritten Stromrichter 124 an den Ausgangsphasen 164, 264, 364 eine zweite Ausgangsspannung 126 aus der ersten Zwischenkreisspannung 109 (in Fig. 3 nicht dargestellt) erzeugt. Da der dritte Stromrichter 124 gemäß einer Ausführungsform sechs Schalter 166, 168 aufweist, wird der dritte Stromrichter 124 gemäß einer Ausführungsform auch als "Sixpack" bezeichnet. Gemäß einer Ausführungsform können die sechs Schalter 166, 168 des dritten Stromrichters 124 gemäß einer Ausführungsform von der ersten Steuervorrichtung 136 derart angesteuert werden, dass bei der ersten Ausgangsspannung 126 eine aktive Leistungsfaktorkorrektur erfolgt.

Gemäß einer Ausführungsform ist dem zweiten Stromrichter 106 und dem dritten Stromrichter 124 ein Temperatursensor 170 zugeordnet (beispielsweise ein Thermistor), beispielsweise wie in Fig. 3 dargestellt. Gemäß einer Ausführungsform bildet der zweite Stromrichter 106 einen Stromrichter eines Leistungsmoduls 172 gemäß Ausführungsformen der hierin offenbarten Gegenstände. Gemäß einer weiteren Ausführungsform bildet der dritte Stromrichter 124 einen weiteren Stromrichter des Leistungsmoduls 172 gemäß Ausführungsformen der hierin offenbarten Gegenstände, beispielsweise einen weiteren Stromrichter, welcher betreibbar ist, um aus der ersten Zwischenkreisspannung 109 die zweite Ausgangsspannung 126 zu erzeugen.

Gemäß einer Ausführungsform ist der zweite Stromrichter 106 an den zweiten Zwischenkreis 110 angeschlossen beispielsweise wie in Fig. 3 dargestellt. Beispielsweise ist gemäß einer Ausführungsform der zweite Stromrichter 106 über den Induktor 148 an das kapazitive Element 122 des zweiten Zwischenkreises 110 angeschlossen, beispielsweise wie in Fig. 2 dargestellt (vgl. auch Fig. 1).

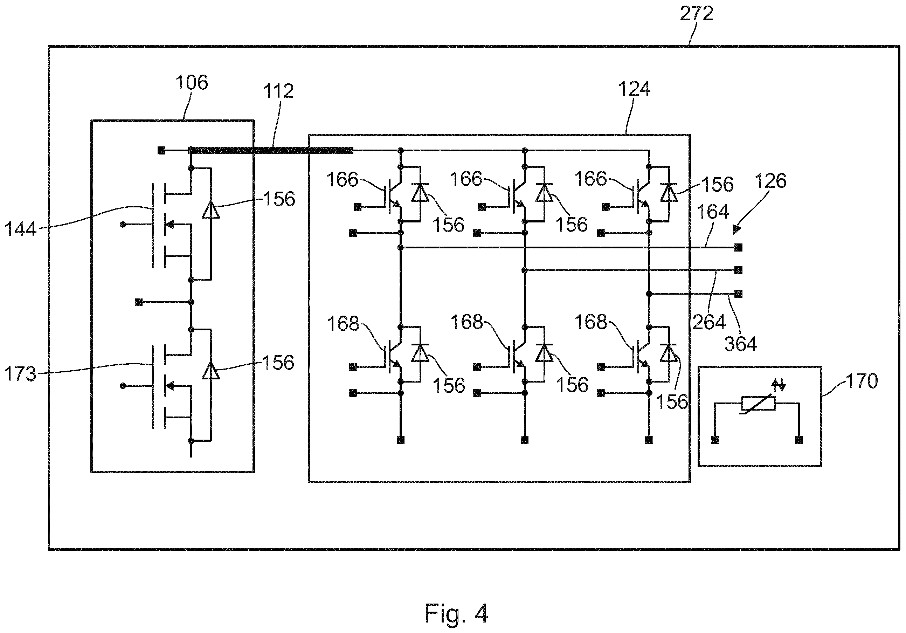

Fig. 4 zeigt eine weitere beispielhafte Implementierung des zweiten Stromrichters 106 und des dritten Stromrichters 124 aus Fig. 1 gemäß Ausführungsformen der hierin offenbarten Gegenstände.

Gemäß einer Ausführungsform sind der zweite Stromrichter 106 und der dritte Stromrichter 124 aus Fig. 4 Teil eines weiteren Leistungsmoduls 272, beispielsweise wie in Fig. 4 dargestellt. Gemäß einer Ausführungsform ist der zweite Stromrichter 106 analog zu dem zweiten Stromrichter 106 aus Fig. 3 ausgebildet, außer dass anstelle der Diode 146 ein zweiter Schalter 173 vorgesehen ist (zusätzlich zu dem Schalter 144 des zweiten Stromrichters 106, welcher auch als erster Schalter 144 des zweiten Stromrichters 106 bezeichnet wird), beispielsweise ein Siliziumscarbid MOSFET, beispielsweise wie in Fig. 4 dargestellt. Gemäß einer Ausführungsform weist der zweite Schalter 173 des zweiten Stromrichters 106 eine Freilaufdiode 156 auf und wird zur Synchrongleichrichtung betrieben, beispielsweise wie in Fig. 4 dargestellt. Der zweite Schalter 173 kann beispielsweise geringere Durchlassverluste als die Diode 146 des zweiten Stromrichters 106 aus Fig. 3 erlauben. Gemäß einer Ausführungsform ist auch der Schalter 144 durch einen Siliziumcarbid MOSFET gebildet, beispielsweise wie in Fig. 4 dargestellt.

Gemäß einer Ausführungsform ist der dritte Stromrichter 124 und der Temperatursensor 170 des Leistungsmoduls 272 identisch mit dem Stromrichter 124 und dem Temperatursensor 170 des Leistungsmoduls 172 aus Fig. 3.

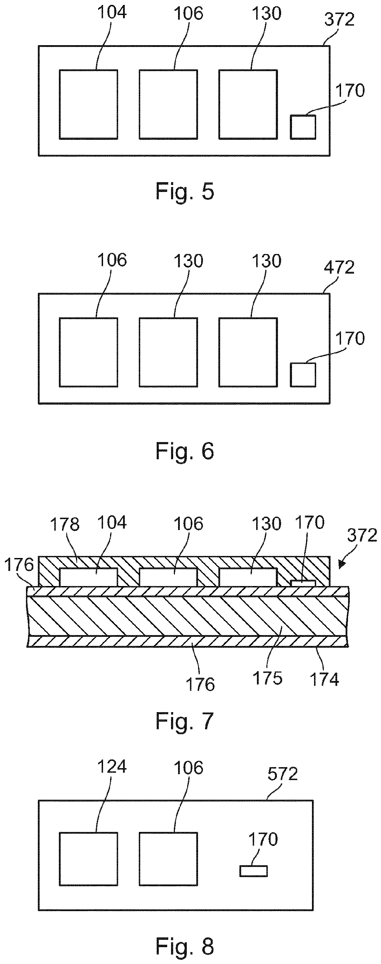

Fig. 5 zeigt ein weiteres Leistungsmodul 372 gemäß Ausführungsformen der hierin offenbarten Gegenstände.

Gemäß einer Ausführungsform weist das Leistungsmodul 372 einen ersten Stromrichter 104, einen zweiten Stromrichter 106 und einen dritten Stromrichter 124 auf, beispielsweise wie in Fig. 5 dargestellt. Gemäß einer weiteren Ausführungsform weist das Leistungsmodul 372 einen Temperatursensor 170 auf, beispielsweise wie in Fig. 5 dargestellt. Gemäß einer Ausführungsform ist (mindestens) eine Komponente mit Leistungshalbleitern, die für das Spannungsniveau des ersten Zwischenkreises konfiguriert sind, beispielsweise der dritte Stromrichter 124, benachbart zu dem Temperatursensor 170 angeordnet, beispielsweise wie in Fig. 5 dargestellt. Gemäß einer Ausführungsform kann eine räumliche Anordnung der Komponenten 104, 106, 124, 170 des Leistungsmoduls 372 verschieden von der Anordnung in Fig. 5 sein.

Gemäß einer Ausführungsform ist der erste Stromrichter 104 ein Vienna-Gleichrichter, beispielsweise wie mit Bezug auf Fig. 1 und/oder Fig. 2 dargestellt und/oder beschrieben. Gemäß einer weiteren Ausführungsform ist der zweite Stromrichter 106 des Leistungsmoduls 372 ein zweiter Stromrichter 106, wie er mit Bezug auf mindestens eine der Fig. 1, Fig. 3 und Fig. 4 dargestellt und/oder beschrieben wurde. Gemäß einer weiteren Ausführungsform ist der dritte Stromrichter 124 des Leistungsmoduls 372 ein dritter Stromrichter 124, wie er mit Bezug auf mindestens eine der Fig. 1, Fig. 3 und Fig. 4 dargestellt und/oder beschrieben wurde. Gemäß einer weiteren Ausführungsform ist der Temperatursensor 170 des Leistungsmoduls 372 einen Temperatursensor 170, wie er mit Bezug auf Fig. 3 und/oder Fig. 4 dargestellt und/oder beschrieben wurde.

Fig. 6 zeigt ein weiteres Leistungsmodul 472 gemäß Ausführungsformen der hierin offenbarten Gegenstände.

Gemäß einer Ausführungsform weist das Leistungsmodul 472 einen zweiten Stromrichter 106 und zwei vierte Stromrichter 130 auf, beispielsweise wie in Fig. 6 dargestellt. Gemäß einer weiteren Ausführungsform weist das Leistungsmodul 472 einen Temperatursensor 170 auf, beispielsweise wie in Fig. 6 dargestellt. Gemäß einer Ausführungsform kann eine räumliche Anordnung der Komponenten 106, 130, 170 des Leistungsmoduls 472 verschieden von der Anordnung in Fig. 6 sein.

Gemäß einer Ausführungsform ist der zweite Stromrichter 106 des Leistungsmoduls 472 ein zweiter Stromrichter 106, wie er mit Bezug auf mindestens eine der Fig. 1, Fig. 3 und Fig. 4 dargestellt und/oder beschrieben wurde. Gemäß einer weiteren Ausführungsform ist jeder vierte Stromrichter 130 des Leistungsmoduls 472 ein vierter Stromrichter 130, wie er mit Bezug auf mindestens eine der Fig. 1, Fig. 3 und Fig. 4 dargestellt und/oder beschrieben wurde. Gemäß einer weiteren Ausführungsform ist der Temperatursensor 170 des Leistungsmoduls 472 einen Temperatursensor 170, wie er mit Bezug auf Fig. 3 und/oder Fig. 4 dargestellt und/oder beschrieben wurde.

Gemäß einer Ausführungsform kann ein Leistungsmodul eine andere Konfiguration als die in den Fig. 3 bis Fig. 6 beschrieben aufweisen und/oder kann gemäß weiteren Ausführungsformen der hierin offenbarten Gegenstände konfiguriert sein.

Fig. 7 zeigt in einer Querschnittsansicht eine Implementierung des Leistungsmoduls 372 aus Fig. 5 gemäß Ausführungsformen der hierin offenbarten Gegenstände.

Gemäß einer Ausführungsform weist das Leistungsmodul 372 ein Wärmeleitelement 174 auf. Gemäß einer Ausführungsform ist das Wärmeleitelement 174 eine Leiterplatte, beispielsweise wie in Fig. 7 dargestellt. Gemäß einer weiteren Ausführungsform ist das Wärmeleitelement 174 eine DBC (Direct Bonded Copper), welche eine Isolatorschicht 175 und zwei Kupferschichten 176 aufweist, beispielsweise wie in Fig. 7 dargestellt. Gemäß einer Ausführungsform sind der erste Stromrichter 104, der zweite Stromrichter 106, der vierte Stromrichter 130 und der Temperatursensor 170 auf dem Wärmeleitelement 174 (d. h. einem einzigen Wärmeleitelement) angeordnet, beispielsweise wie in Fig. 7 dargestellt. Gemäß einer weiteren Ausführungsform sind der erste Stromrichter 104, der zweite Stromrichter 106, der vierte Stromrichter 130 und der Temperatursensor 170 in einem gemeinsamen Gehäuse 178 angeordnet, beispielsweise in einem gegossenen Gehäuse 178, wie in Fig. 7 dargestellt.

Fig. 8 zeigt ein weiteres Leistungsmodul 572 gemäß Ausführungsformen der hierin offenbarten Gegenstände.

Gemäß einer Ausführungsform weist das Leistungsmodul 572 einen zweiten Stromrichter 106 und einen dritten Stromrichter 124 auf, beispielsweise wie in Fig. 8 dargestellt. Gemäß einer weiteren Ausführungsform weist das Leistungsmodul 572 einen Temperatursensor 170 auf, beispielsweise wie in Fig. 8 dargestellt. Gemäß einer Ausführungsform ist der zweite Stromrichter 106 zwischen dem dritten Stromrichter 124 und dem Temperatursensor 170 angeordnet, beispielsweise wie in Fig. 8 dargestellt. Gemäß einer Ausführungsform kann eine räumliche Anordnung der Komponenten 104, 106, 124, 170 des Leistungsmoduls 572 verschieden von der Anordnung in Fig. 8 sein.

Gemäß einer Ausführungsform sind die Komponenten der in den Fig. 5 bis Fig. 8 dargestellten Leistungsmodule gemäß einer oder mehreren Ausführungsformen ausgebildet, wie sie mit Bezug auf die Fig. 1 bis Fig. 4 beschrieben wurden.

Gemäß einer Ausführungsform ist das induktive Element 120 ein separates Element, d.h. gemäß einer Ausführungsform ist das induktive Element 120 nicht Teil eines Leistungsmoduls, wie es hierin beschrieben ist.

Gemäß Ausführungsformen der hierin offenbarten Gegenstände kann jede geeignete Entität (z. B. Komponenten, Einheiten und Vorrichtungen, etc.) zumindest teilweise in der Form von entsprechenden Computerprogrammen bereitgestellt sein, welche es einer Prozessorvorrichtung ermöglichen, die Funktionalität der entsprechenden Entität zu liefern, wie sie hierin beschrieben ist. Gemäß anderer Ausführungsformen kann jede geeignete Entität, wie sie hierin beschrieben ist, in Hardware bereitgestellt sein. Gemäß anderer, Hybrid-Ausführungsformen können einige Entitäten in Software bereitgestellt sein, während andere Entitäten in Hardware bereitgestellt sind.

Es wird darauf hingewiesen, dass jede hierin offenbarte Entität (z. B. Komponenten, Einheiten, Vorrichtungen, Elemente, Schalter, etc.) nicht auf eine dezidierte Entität beschränkt ist, wie sie in einigen Ausführungsformen beschrieben sind. Vielmehr kann können die hierin beschriebenen Gegenstände auf verschiedene Weisen mit verschiedener Granularität auf Vorrichtungs-Niveau oder auf Softwaremodul-Niveau bereitgestellt sein, während sie immer noch die angegebene Funktionalität liefern. Ferner sollte angemerkt werden, dass gemäß Ausführungsformen eine separate Entität (z. B. ein Softwaremodul, ein Hardwaremodul oder ein Hybridmodul) für jede der hierin offenbarten Funktionen bereitgestellt sein kann. Gemäß anderer Ausführungsformen kann eine Entität (z. B. ein Softwaremodul, in Hardwaremodul oder ein Hybridmodul) konfiguriert sein, um zwei oder mehr Funktionen, wie sie hierin beschrieben sind, zu liefern. Gemäß nochmals anderen Ausführungsformen können zwei oder mehr Entitäten (z. B. Komponenten, Einheiten und Vorrichtungen, Elemente, Schalter, etc.) konfiguriert sein, um zusammen eine Funktion, wie sie hierin beschrieben ist, zu liefern.

Gemäß einer Ausführungsform enthält eine Steuervorrichtung eine Prozessorvorrichtung, welche mindestens einen Prozessor aufweist zum Ausführen von mindestens einem Programmelement, welches einem entsprechenden Softwaremodul entsprechen kann.

Es wird darauf hingewiesen, dass die hierin beschriebenen Implementierungen lediglich eine beschränkte Auswahl an möglichen Kombinationen von Ausführungsformen der vorliegenden Offenbarung darstellen. So ist es allgemein möglich, die Merkmale verschiedener Ausführungsformen in geeigneter Weise miteinander zu kombinieren, so dass für den Fachmann mit den hier explizit offenbarten Ausführungsformen eine Vielzahl von Kombinationen verschiedener Ausführungsformen als offenbart anzusehen sind. Ferner sollte erwähnt werden, dass Begriffe wie "ein" oder "eines" eine Mehrzahl nicht ausschließen. Begriffe wie "enthaltend" oder "aufweisend" schließen weitere Merkmale oder Verfahrensschritte nicht aus. Folglich steht gemäß einer Ausführungsform der Begriff "aufweisend" oder "enthaltend" für "unter anderem aufweisend". Gemäß einer weiteren Ausführungsform steht der Begriff "aufweisend" oder "enthaltend" für "bestehend aus". Gemäß einer Ausführungsform umfasst der Begriff "eingerichtet für" unter anderem die Bedeutung "konfiguriert, um".

Der Begriff "insbesondere" bezeichnet hierin allgemein optionale Merkmale.

Der Ausdruck "A und/oder B" umfasst in üblicher Weise stets "nur A", "nur B" sowie auch "A und B". In einem Ausdruck, der auf eine Auflistung von Merkmalen Bezug nimmt, umfasst "mindestens eines" stets die einzelnen Merkmale sowie beliebige Kombinationen der Merkmale. Beispielsweise umfasst der Ausdruck "mindestens eines der Merkmale A und B" das Merkmal "nur A", "nur B", sowie "A und B". Analog umfasst auch der Ausdruck "mindestens eines der Merkmale A oder B" das Merkmal "nur A", "nur B", sowie "A und B". Analog umfasst auch der Ausdruck "mindestens eines der Merkmale A, B" das Merkmal "nur A", "nur B", sowie "A und B".

Es sollte auch angemerkt werden, dass Bezugszeichen in den Ansprüchen nicht als den Umfang der Ansprüche einschränkend ausgelegt werden sollten. Ferner sollte angemerkt werden, dass Bezugszeichen in der Beschreibung und die Bezugnahme der Beschreibung auf die Zeichnungen nicht als den Umfang der Beschreibung einschränkend ausgelegt werden sollen. Vielmehr veranschaulichen die Zeichnungen nur eine exemplarische Implementierung einer bestimmten Kombination von mehreren Ausführungsformen der hierin offenbarten Gegenstände, wobei jede andere Kombination von Ausführungsformen ebenso möglich und mit dieser Anmeldung als offenbart anzusehen ist.

### Zusammenfassend bleibt festzustellen:

Offenbart wird eine elektronische Schaltung 102, aufweisend: einen ersten Stromrichter 104 zum Erzeugen einer ersten Zwischenkreisspannung 109 an einem ersten Zwischenkreis 108; einen zweiten Stromrichter zum Erzeugen einer zweiten Zwischenkreisspannung 111 an einem zweiten Zwischenkreis 110; wobei der zweite Stromrichter 106 an den ersten Zwischenkreis 108 angeschlossen ist zum Speisen des zweiten Stromrichters 106 mit der ersten Zwischenkreisspannung 109; und wobei die erste Zwischenkreisspannung 109 sich von der zweiten Zwischenkreisspannung 111 unterscheidet. Ferner werden ein Verfahren, ein Leistungsmodul und eine elektrische Vorrichtung offenbart.

### BEZUGSZIFFERNLISTE

100 elektrische Vorrichtung
102 elektronische Schaltung
104 erster Stromrichter
106 zweiter Stromrichter
108 erster Zwischenkreis
109 erste Zwischenkreisspannung
110 zweiter Zwischenkreis
111 zweite Zwischenkreisspannung
112 Anschluss an ersten Zwischenkreis
114 Stromnetz
116 EMV Filter
120 Induktives Element zur Leistungsfaktorkorrektur (Induktivität)
122 kapazitives Element (Kondensator)
124 dritter Stromrichter
126 erste Ausgangsspannung
128 erster Verbraucher
130 vierter Stromrichter
131 Anschluss an zweiten Zwischenkreis
132 zweite Ausgangsspannung
134 zweiter Verbraucher
136 erste Steuervorrichtung
138 Treiber
140 zweite Steuervorrichtung
142 Steuern/Regeln
144 (erster) Schalter des zweiten Stromrichters
146 Diode des zweiten Stromrichters
148 Induktor
150 Strommessvorrichtung
152 kommunikative Kopplung
154 erster Schalter des ersten Stromrichters
156 Freilaufdiode
158 erste Phase des ersten Stromrichters
159 Brückenschaltung
160 Dioden der Brückenschaltung 159
162 Vollbrücke
164 erste Ausgangsphase
166 erster Schalter einer Phase der Vollbrücke
168 zweiter Schalter einer Phase der Vollbrücke
170 Temperatursensor
172 Leistungsmodul
173 zweiter Schalter des zweiten Stromrichters
174 Wärmeleitelement
175 Isolatorschicht
176 Kupferschicht
178 gemeinsames Gehäuse
254 zweiter Schalter des ersten Stromrichters
258 zweite Phase des ersten Stromrichters
264 zweite Ausgangsphase
272 Leistungsmodul
358 dritte Phase des ersten Stromrichters
364 dritte Ausgangsphase
372 Leistungsmodul
472 Leistungsmodul

## Patentansprüche

1. Elektronische Schaltung (102), aufweisend:
einen ersten Stromrichter (104) zum Erzeugen einer ersten Zwischenkreisspannung (109) an einem ersten Zwischenkreis (108);
einen zweiten Stromrichter (106) zum Erzeugen einer zweiten Zwischenkreisspannung (111) an einem zweiten Zwischenkreis (110);
wobei der zweite Stromrichter (106) an den ersten Zwischenkreis (108) angeschlossen ist zum Speisen des zweiten Stromrichters (106) mit der ersten Zwischenkreisspannung (109); und
wobei die erste Zwischenkreisspannung (109) sich von der zweiten Zwischenkreisspannung (111) unterscheidet.

2. Elektronische Schaltung (102) gemäß Anspruch 1, wobei der erste Stromrichter (104) ein Gleichrichter ist, welcher aus einer Versorgungsspannung die erste Zwischenkreisspannung (109) erzeugt.

3. Elektronische Schaltung (102) gemäß irgendeinem der Ansprüche 1 oder 2, wobei der erste Stromrichter (104) konfiguriert ist, um eine Leistungsfaktorkorrektur zu liefern.

4. Elektronische Schaltung (102) gemäß irgendeinem der Ansprüche 1 bis 3, wobei der zweite Stromrichter (106) ein Tiefsetzsteller ist.

5. Elektronische Schaltung (102) gemäß einem der vorhergehenden Ansprüche wobei der erste Stromrichter (104) und der zweite Stromrichter (106) an ein gemeinsames Wärmeleitelement (174) gekoppelt sind.

6. Elektronische Schaltung (102) gemäß Anspruch 5, wobei das gemeinsame Wärmeleitelement (174) eine Leiterplatte, insbesondere eine DBC, ist, ferner aufweisend mindestens eines von dem folgenden:
die Leiterplatte liefert eine elektrisch leitende Verbindung mit mindestens einem Teil von elektrischen Anschlüssen des ersten Stromrichters (104); und
die Leiterplatte liefert eine elektrisch leitende Verbindung mit mindestens einem Teil von elektrischen Anschlüssen des zweiten Stromrichters (106).

7. Elektronische Schaltung (102) gemäß irgendeinem der vorhergehenden Ansprüche, wobei der erste Stromrichter (104) und der zweite Stromrichter (106) in einem gemeinsamen Gehäuse (178) angeordnet sind.

8. Elektronische Schaltung (102) gemäß irgendeinem der vorhergehenden Ansprüche, ferner aufweisend mindestens eines von dem folgenden:
einen dritten Stromrichter (124), welcher an den ersten Zwischenkreis (108) angeschlossen ist, wobei der dritte Stromrichter (124) konfiguriert ist zum Erzeugen einer ersten Ausgangsspannung (126) aus der ersten Zwischenkreisspannung (109);
mindestens einen vierten Stromrichter (130), welcher an den zweiten Zwischenkreis (110) angeschlossen ist, wobei der mindestens eine vierte Stromrichter (130) konfiguriert ist zum Erzeugen einer zweiten Ausgangsspannung (132) aus der zweiten Zwischenkreisspannung (111).

9. Elektronische Schaltung (102) gemäß Anspruch 8, ferner aufweisend mindestens eines von dem folgenden:
der dritte Stromrichter (124) ist ein Inverter;
der vierte Stromrichter (130) ist ein Inverter;
der dritte Stromrichter (124) ist zum Ansteuern eines ersten Verbrauchers (128) konfiguriert;
jeder vierte Stromrichter (130) von dem mindestens einen vierten Stromrichter (130) ist zum Ansteuern eines zweiten Verbrauchers (134) konfiguriert;
der zweite Stromrichter (106) und mindestens ein vierter Stromrichter (130) von dem mindestens einen vierten Stromrichter (130) sind an ein gemeinsames Wärmeleitelement (174) gekoppelt und/oder in einem gemeinsamen Gehäuse (178) angeordnet, insbesondere wobei das gemeinsame Wärmeleitelement (174) eine Leiterplatte ist;
der erste Stromrichter (104), der zweite Stromrichter (106) und der dritte Stromrichter (124) sind an ein gemeinsames Wärmeleitelement (174) gekoppelt;
der zweite Stromrichter (106) und der dritte Stromrichter (124) sind in einem gemeinsamen Gehäuse angeordnet.

10. Elektronische Schaltung (102) gemäß irgendeinem der vorhergehenden Ansprüche, ferner aufweisend
eine erste Steuervorrichtung (136) zum Steuern des ersten Stromrichters (104); und
eine zweite Steuervorrichtung (140) zum Steuern des zweiten Stromrichters (106).

11. Verfahren aufweisend:
Erzeugen einer ersten Zwischenkreisspannung (109) aus einer Versorgungsspannung;
Erzeugen einer zweiten Zwischenkreisspannung (111) aus der ersten Zwischenkreisspannung (109).

12. Verfahren gemäß Anspruch 11, ferner aufweisend:
Erzeugen einer ersten Ausgangsspannung (126) aus der ersten Zwischenkreisspannung (109);
Erzeugen einer zweiten Ausgangsspannung (132) aus der zweiten Zwischenkreisspannung (111), wobei die zweite Ausgangsspannung (132) kleiner als die erste Ausgangsspannung (126) ist.

13. Leistungsmodul (172, 272, 372, 472) aufweisend:
einen Stromrichter (106), welcher betreibbar ist, um aus einer ersten Zwischenkreisspannung (109) eine zweite Zwischenkreisspannung (111) zu erzeugen; und
einen weiteren Stromrichter (130), welcher betreibbar ist, um aus der zweiten Zwischenkreisspannung (111) eine Ausgangsspannung (132) zu erzeugen.

14. Leistungsmodul (172, 272, 372, 472) gemäß Anspruch 13, wobei der Stromrichter (106) und der weitere Stromrichter (130) in einem gemeinsamen Gehäuse (178) angeordnet sind.

15. Elektrische Vorrichtung aufweisend eine elektronische Schaltung (102) gemäß irgendeinem der Ansprüche 1 bis 10 und/oder oder ein Leistungsmodul (172, 272, 372, 472) gemäß irgendeinem der Ansprüche 13 bis 14.
